# EUROPÄISCHE PATENTANMELDUNG

(11) **EP 3 543 594 A1**
(43) Veröffentlichungstag der Anmeldung: **25.09.2019**
(21) Anmeldenummer: 18162481.8
(22) Anmeldetag: 19.03.2018
(51) Int. Cl.: F21S 41/148, F21S 41/365, F21S 41/43, H01L 33/60

(54) **KRAFTFAHRZEUG-SCHEINWERFER**

(71) Anmelder: ZKW Group GmbH, 3250 Wieselburg (AT)
(72) Erfinder: Edlinger, Erik, 1090 Wien (AT)
(74) Vertreter: Patentanwaltskanzlei Matschnig & Forsthuber OG

(57) **Zusammenfassung**

Ein Kraftfahrzeug-Scheinwerfer (1) mit zumindest einer auf einer Leiterplatte (3) aufgelöteten LED (4), wobei die Hauptabstrahlrichtung der zumindest einen LED zu einem Reflektor (2) gerichtet ist, welcher das von der zumindest einen LED abgestrahlte Licht in den Verkehrsraum abstrahlt, wobei zum gezielten Einfang von außerhalb der Hauptabstrahlrichtung der zumindest einen LED (4) auftretender Randstrahlung und zur Reflexion solcher Randstrahlung in Richtung des Reflektors (2) im Bereich dieser Randstrahlung zumindest ein Minireflektor (6) auf der Leiterplatte (3) angeordnet ist, dessen Größe so gewählt ist, dass die Abstrahlung des Lichtes in den Verkehrsraum durch den Minireflektor im Wesentlichen nicht behindert ist.

## Beschreibung

Die Erfindung bezieht sich auf einen Kraftfahrzeug-Scheinwerfer mit zumindest einer auf einer Leiterplatte aufgelöteten LED, wobei die Hauptabstrahlrichtung der zumindest einen LED zu einem Reflektor gerichtet ist, welcher das von der zumindest einen LED abgestrahlte Licht in den Verkehrsraum abstrahlt.

Ein Problem bei Scheinwerfern der gegenständlichen Art liegt darin, dass eine LED als solche zwar eine sehr kleine Abstrahlfläche aufweist, in der Praxis jedoch eine Leiterplatte benötigt, auf welcher sie durch Löten mit stromführenden Leiterbahnen verbunden ist. Oft sind die LEDs als SMD-Bauelemente (**S**urface **M**ounted **D**evice) ausgebildet, die mit ihren elektrischen Anschlüssen, meist kurz "Pads" genannt, direkt auf die Leiterplatte aufgelötet sind, wobei vorzugsweise ein Reflow-Verfahren angewandt wird. Vor allem aber wird die Leiterplatte, meist zusammen mit auf dieser angeordneten Kühlelementen zur Kühlung der LED oder LEDs benötigt, denn das Fehlen einer geeigneten Kühlung würde bei den im Scheinwerferbereich verwendeten Hochleistungs-LEDs zu deren Zerstörung, auf jeden Fall aber zu einer unerträglichen Verminderung ihrer Lebensdauer führen.

Die Leiterplatte stellt jedoch in dem Scheinwerfer für dessen optisches System ein Problem dar, da die darauf aufgelötete LED bzw. aufgelöteten LEDs parallel zur Leiterplattenebene liegen und ohne besondere Vorkehrungen nicht hinsichtlich ihrer Abstrahlrichtung justierbar sind. Dies führt dazu, dass ein Teil des von der LED oder den LEDs abgestrahlten Lichts ungenutzt bleibt und/oder bei Verwendung eines Reflektors im Scheinwerfer die Leiterplatte einen Teil des von dem Reflektor abgestrahlten Lichts abschatten kann. Dabei ist zu bedenken, dass LEDs im Gegensatz zu vielen anderen konventionellen Leuchtmitteln nur einen begrenzten Öffnungswinkel besitzen und somit bezogen auf eine Kugeloberfläche in einen Teilwinkel strahlen, sodass man optische Systeme, die beispielsweise für Glühlampen geeignet sind, nicht kritiklos übernehmen kann und sich spezifische Probleme, auf die weiter unten noch eingegangen wird, ergeben, welche den Gesamtwirkungsgrad herabsetzen.

Insbesondere gibt es bei LEDs eine Hauptabstrahlrichtung und außerhalb dieser Hauptabstrahlrichtung tritt eine Randstrahlung auf, welche den Reflektor des Scheinwerfers nicht erreicht, dadurch verloren geht und den Wirkungsgrad herabsetzt.

Eine Aufgabe der Erfindung liegt darin, einen Scheinwerfer zu schaffen, bei welchem so viel wie möglich dieser Randstrahlung "eingefangen" und nutzbar gemacht werden kann.

Diese Aufgabe wird mit einem Scheinwerfer der eingangs angegebenen Art gelöst, bei welchem erfindungsgemäß zum gezielten Einfang von außerhalb der Hauptabstrahlrichtung der zumindest einen LED auftretender Randstrahlung und zur Reflexion solcher Randstrahlung in Richtung des Reflektors im Bereich dieser Randstrahlung zumindest ein Minireflektor auf der Leiterplatte angeordnet ist, dessen Größe so gewählt ist, dass die Abstrahlung des Lichtes in den Verkehrsraum durch den Minireflektor im Wesentlichen nicht behindert ist.

Bei einer zweckmäßigen Ausbildung der Erfindung kann vorgesehen sein, dass der Minireflektor einen lötbaren Fußabschnitt aufweist, mit welchem er auf der Leiterplatte aufgelötet ist.

Dabei kann es sehr vorteilhaft sein, wenn sowohl die zumindest eine LED als auch der zumindest eine Minireflektor nach dem SMD-Verfahren aufgelötet sind

Bei praxisfreundlichen Anwendungen ist es günstig, wenn der zumindest einen LED genau ein Minireflektor zugeordnet ist

Die Erfindung bewährt sich besonders bei einem Scheinwerfer, bei welchem der Reflektor als Halbschalenreflektor ausgebildet ist.

Vorteilhaft ist es weiters, wenn die Leiterplatte mit der zumindest einen LED im Wesentlichen in der Schnittebene, welche auch die optische Achse der Scheinwerferoptik enthält, liegt.

Die Erfindung samt weiterer Vorteile ist im Folgenden an Hand beispielsweiser Ausführungsformen näher erläutert, die in der Zeichnung veranschaulicht sind. In dieser zeigt

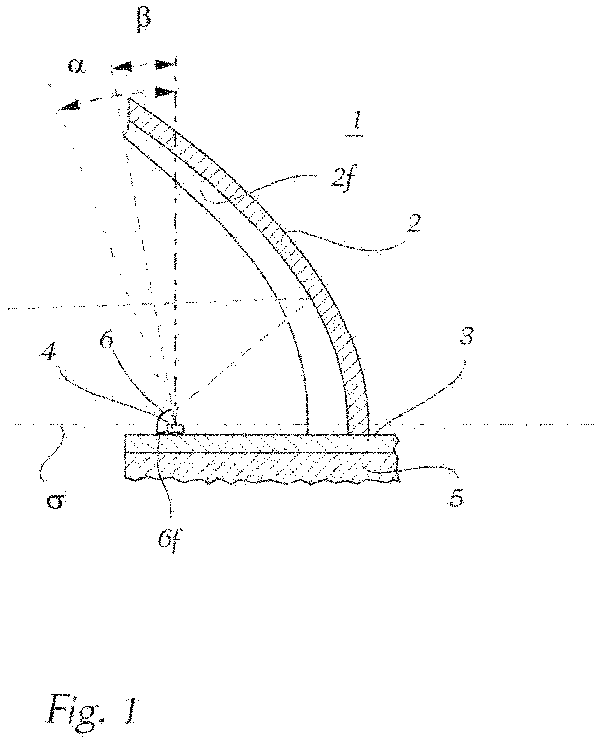

Fig. 1 einen Scheinwerfer mit einem Halbschalenreflektor in einem schematischen Schnitt mit einer auf einer Leiterplatte angeordneten LED-Lichtquelle.

Bezug nehmend auf **Fig. 1** erkennt man in schematischer Ansicht einen Scheinwerfer **1** nach der Erfindung mit seinen für die Erläuterung der Erfindung wesentlichen Bestandteilen, wobei es für den Fachmann klar ist, dass ein Schweinwerfer eine Vielzahl weiterer, hier nicht gezeigter Bestandteile besitzt, wie Ein- und Verstelleinrichtungen, elektrische Versorgungsmittel und vieles mehr. Wenn im Zusammenhang mit der Erfindung der Begriff "Scheinwerfer" verwendet wird, so soll dieser Begriff auch einzelne Projektionsmodule beinhalten, die auch in Kombination in einem übergeordneten Scheinwerfer enthalten sein können. Fig. 1 zeigt weiters einen Reflektor **2,** und eine auf einer Leiterplatte 3 angeordnete LED-Lichtquelle **4,** im folgernden meist kurz LED 4 genannt.

Begriffe hinsichtlich des Ortes oder einer Orientierung, wie beispielsweise "oben", "unten", "vorne", "darunter", "darüber" etc. werden in der Beschreibung lediglich zur Vereinfachung gewählt und beziehen sich möglicherweise auf die Darstellung in der Zeichnung nicht jedoch notwendigerweise auf eine Gebrauchs- oder Einbaulage.

Mit dem Bezugszeichen **5** ist ein Kühlkörper oder ein Teil des Gehäuses des Scheinwerfers 1 bezeichnet. Der Reflektor 2 ist beispielsweise als HalbschalenReflektor ausgebildet und zeigt bei einer Ausführungsform weniger ein Paraboloid als eine Aneinanderreihung von Facetten, die jedoch einer Paraboloidfläche entnommen sein könnten. Eine Facette ist im Schnitt gezeigt, bei einer benachbarten blickt man unter flachem Winkel auf die Reflektor-Innenfläche **2f,** die hier nur eine geringe Umschließung aufweist. Die Leiterplatte 3 mit der LED-Lichtquelle 4 liegt im Wesentlichen in der Schnittebene σ, welche auch die nicht näher bezeichnete optische Achse des Scheinwerfers 1 enthält. Die Reflektoröffnung befindet sich im Bereich des Brennpunkts bzw. des Ortes der LED-Lichtquelle 4. Vom Halbraum in Lichtaustrittsrichtung des Reflektors treffen bei diesem Beispiel nur Strahlen in einem Winkel β von ca. 10° gemessen von der Hauptabstrahlrichtung der LED mit einem Gesamtabstrahlungswinkel von größer als α auf die Reflektor-Innenfläche 2f. Jener Teil der LED-Strahlung, welcher den Reflektor 2, nämlich seine reflektierende Innenseite nicht erreicht, wird im Rahmen dieser Erfindungsbeschreibung als "Randstrahlung" bezeichnet.

Um Verluste durch diese Randstrahlung zu vermeiden, könnte man durch Neigen der Leiterplatte 3 mehr in Richtung des Inneren des Reflektors 2 versuchen, die Lichtausbeute zu erhöhen, da durch ein solches Neigen auch die von der LED ausgehende Strahlung insgesamt mehr in das Innere des Reflektors rückt. Allerdings hätte dies zur Folge, dass die geneigte Leiterplatte 3 samt darauf sitzenden Elementen einen Bereich der von dem Reflektor 2 nach vorne in den Verkehrsraum ausgehenden Strahlung abgeschattet wird. Diese Abschattung führt natürlich erneut zu Lichtverlusten und ist auch lichttechnisch unerwünscht.

Eine andere Möglichkeit besteht darin, nicht die Leiterplatte sondern die LED 4 in Richtung des Reflektors 2 nach hinten zu neigen, was beispielsweise durch unterschiedliche Lotdicken im Zuge des Lötvorganges realisiert werden kann. In optischer Hinsicht ist diese Lösung zwar vorteilhaft, doch ist das Einstellen der Lotdicke ein verfahrenstechnisch kritischer Vorgang.

Die beiden zuvor genannten Möglichkeiten der Neigung der Leiterplatte samt LED bzw. der LED alleine sind in der AT 518 666 A1 der Anmelderin geoffenbart.

Die Erfindung sieht nun zum "Einfangen" der Randstrahlung eine andere Lösung vor, nämlich die Verwendung zumindest eines Minireflektors. In Fig. 1 erkennt man, dass im Nahbereich der LED 4 vor dieser ein solcher Minireflektor 6 auf der Leiterplatte 3 sitzt. Im gezeigten Beispiel ist dieser Minireflektor 6 mit einem metallischen Fußabschnitt **6f** auf einen metallischen Bereich der Leiterplatte 3, z.B. auf ein Kupferpad, aufgelötet. Anzumerken ist, dass auch die LED 4 oder auch mehrere LEDs mit ihren elektrischen Anschlüssen auf zugehörige Leiterbahnabschnitte der Leiterplatte 3 aufgelötet sind, wobei zur Vereinfachung Leiterbahnabschnitte bzw. metallische Flächenbereiche der Leiterplatte 3 in der Zeichnung nicht eingezeichnet sind. Zum Anordnen der LED 4 und des Minireflektors 6 sowie allfällig anderer Bauteile auf der Leiterplatte 3 werden zweckmäßigerweise dem Fachmann bekannte Verfahren zum Bestücken und Löten von SMD-Bauteilen verwendet.

Wie man der Zeichnung entnehmen kann, wird LED-Strahlung, welche sich über den Bereich "β" bis zur äußeren Grenze des Bereiches "α" erstreckt, an dem Minireflektor 6 in Richtung des Scheinwerfer-Reflektors 2 reflektiert und damit nutzbar gemacht. Zwar wird ein geringer Teil des von dem Reflektor 2 nach vorne reflektierten Lichtes durch den Minireflektor 6 wieder abgefangen bzw. abgeschattet, doch ist dieser Anteil zufolge der geringen Ausdehnung des Minireflektors meist vernachlässigbar gering.

Die Geometrie bzw. die Abmessungen des Minireflektors 6 werden in Abhängigkeit von der jeweilige Geometrie des Scheinwerfers 1, insbesondere seines Reflektors 2 bestimmt. Unter "Minireflektor" ist im Zusammenhang mit der vorliegenden Erfindung ein Reflektor 6 zu verstehen, dessen Abmessungen erheblich geringer sind, als jene des eigentlichen Scheinwerfer-Reflektors 2, und die, wie bereits angedeutet, auch so gewählt sind, dass die Abstrahlung des Lichtes in den Verkehrsraum durch den Minireflektor im Wesentlichen nicht behindert ist.

Die Oberfläche des Minireflektors 6 sollte, jedenfalls in seinem dem Reflektor 2 zugewandten Bereich, stark reflektierend sein. Zumindest der Fußabschnitt 6f des Minireflektors 6 muss, wenn man ein Lötverfahren zur Befestigung verwendet, lötbar sein. Die Form des Minireflektors 6 kann je nach optischer Auslegung von einfachen geraden Blechen bis hin zu komplexen Halbkugelgeometrien oder Beugungsgittern reichen.

Im Allgemeinen ist einer LED 4 genau ein Minireflektor 6 zugeordnet, möglich ist es jedoch, beispielsweise einer LED 4 zwei Minireflektoren 6 zuzuordnen, wenn es beispielsweise für eine besondere optische Geometrie oder aus anderen, z.B. thermischen Gründen, zweckmäßig erscheint.

Falls der Minireflektor 6 aus einem wärmeleitenden Metall besteht, bietet er einen weiteren Vorteil durch die zusätzliche Kühlwirkung seines Blechs, das neben der optischen auch eine thermische Aufgabe erfüllt. Die Wärme des Minireflektors 6 kann beispielsweise über dem Fachmann bekannte Cu-Vias durch die Leiterplatte 3 zu dem Kühlkörper 5 abgeleitet werden.

Nicht unerwähnt bleiben soll als zusätzlicher Vorteil, dass dem Minireflektor 6 auch eine Schirmfunktion gegen insbesondere von der LED ausgehende EMV-Störungen zukommen kann.

Um Beispiele für Metalle bzw. Legierungen zu geben, die sich gut für Minireflektoren 6 eignen, seien angeführt:
einfache Zinnbronzen aus Kupfer und Zinn im Mischungsverhältnis von 4:1 bis 2:1, teilweise unter Zusatz von 1 bis 2 % Arsen.
71-72 % Kupfer, 18-19 % Zinn, 4-4,5 % Antimon und Blei.
80,8 % Kupfer, 9,1 % Blei, 8,4 % Antimon.

Platin und Stahl im Verhältnis 1:1.

350 Teile Kupfer, 165 Teile Zinn, 20 Teile Zink, 10 Teile Arsen, 60 Teile Platin.

Wegen seiner guten thermischen Leitfähigkeit bei geringem wirtschaftlichem Aufwand kann auch verzinntes oder mit einer anderen Oberflächenbeschichtung versehenes Kupferblech in Frage kommen.

Wenngleich ein Auflöten des Minireflektors 6 das bevorzugte Verfahren zur Befestigung auf der Leiterplatte ist, soll nicht ausgeschlossen werden, dass an Stelle eines Lötverfahrens auch Klebeverfahren in Frage kommen oder auch kraft/formschlüssige Verbindungen des Minireflektors 6 mit der Leiterplatte.

Unter dem Begriff "LED" soll im Rahmen der Erfindung ganz allgemein ein lichtabstrahlendes Element, insbesondere ein SMD-Element verstanden werden, beispielsweise auch sogenannte Multichip-LEDs, die mehrere lichtabstrahlende Flächen ausweisen, blaue LEDs in Verbindung mit einem Leuchtstoff, die ein "weißes" Mischlicht abstrahlen etc.

Die in den folgenden Ansprüchen verwendeten Bezugszeichen sollen lediglich die Lesbarkeit der Ansprüche und das Verständnis der Erfindung erleichtern und haben keinesfalls einen den Schutzumfang der Erfindung beeinträchtigenden Charakter.

**Liste der Bezugszeichen**

| | | | |
|---|---|---|---|
| 1 | Scheinwerfer | a | optische Achse |
| 2 | Reflektor | b | Bereich |
| 2f | Reflektor-Innenfläche | α | Gesamtabstrahl-Winkel |
| 3 | Leiterplatte | β | Winkel |
| 4 | LED | | |
| 5 | Kühlkörper | | |
| 6 | Minireflektor | | |
| 6f | Fußabschnitt | | |

## Patentansprüche

1. Kraftfahrzeug-Scheinwerfer (1) mit zumindest einer auf einer Leiterplatte (3) aufgelöteten LED (4), wobei die Hauptabstrahlrichtung der zumindest einen LED zu einem Reflektor (2) gerichtet ist, welcher das von der zumindest einen LED abgestrahlte Licht in den Verkehrsraum abstrahlt,
**dadurch gekennzeichnet, dass**
zum gezielten Einfang von außerhalb der Hauptabstrahlrichtung der zumindest einen LED (4) auftretender Randstrahlung und zur Reflexion solcher Randstrahlung in Richtung des Reflektors (2) im Bereich dieser Randstrahlung zumindest ein Minireflektor (6) auf der Leiterplatte (3) angeordnet ist, dessen Größe so gewählt ist, dass die Abstrahlung des Lichtes in den Verkehrsraum durch den Minireflektor im Wesentlichen nicht behindert ist.

2. Kraftfahrzeug-Scheinwerfer (1) nach Anspruch 1, **dadurch gekennzeichnet, dass** der Minireflektor (6) einen lötbaren Fußabschnitt (6f) aufweist, mit welchem er auf der Leiterplatte (3) aufgelötet ist.

3. Kraftfahrzeug-Scheinwerfer (1) nach Anspruch 2, **dadurch gekennzeichnet, dass** sowohl die zumindest eine LED (4) als auch der zumindest eine Minireflektor (6) nach dem SMD-Verfahren aufgelötet sind

4. Kraftfahrzeug-Scheinwerfer (1) nach einem der Ansprüche 1 bis 3, **dadurch gekennzeichnet, dass** der zumindest einen LED (4) genau ein Minireflektor (6) zugeordnet ist

5. Kraftfahrzeug-Scheinwerfer (1) nach einem der Ansprüche 1 bis 4, **dadurch gekennzeichnet, dass** der Reflektor (2) als Halbschalenreflektor ausgebildet ist.

6. Kraftfahrzeug-Scheinwerfer (1) nach einem der Ansprüche 1 bis 5, **dadurch gekennzeichnet, dass** die Leiterplatte (3) mit der zumindest einen LED (4) im Wesentlichen in der Schnittebene (σ), welche auch die optische Achse der Scheinwerferoptik enthält, liegt.
